# Europäisches Patentamt
# European Patent Office
# Office européen des brevets

(19)

(11)   **EP 0 755 086 A2**

(12)   **EUROPEAN PATENT APPLICATION**

(43) Date of publication:
**22.01.1997  Bulletin 1997/04**

(51) Int. Cl.$^6$: **H01L 43/08**

(21) Application number: **96111636.5**

(22) Date of filing: **18.07.1996**

(84) Designated Contracting States:
**DE FR GB**

(30) Priority: **21.07.1995 JP 207906/95**

(71) Applicant: **SONY CORPORATION**
**Tokyo (JP)**

(72) Inventor: **Sugawara, Nobuhiro**
**Shinagawa-ku, Tokyo (JP)**

(74) Representative: **TER MEER - MÜLLER -**
**STEINMEISTER & PARTNER**
**Mauerkircherstrasse 45**
**81679 München (DE)**

(54)   **Magnetoresistive device**

(57)   A magnetoresistive device, especially a giant-magnetoresistive device of a spin-valve type, i.e. SV device, having a multi-layer structure comprising an active layer (free layer) in which the direction of the magnetization spin (i.e. magnetic moment) rotates in response to an external magnetic field (or Hext), a non-magnetic layer (spacer), and a magnetic layer for magnetization fixation (pinning layer or hard magnetic layer), those layers being stacked in a described order or the reverse of said order, and the thickness of the active layer being 5.0 mm or less. In such a magnetoresistive device, linearity of the operating characteristics can be improved by inhibition of AMR effects (anisotropic magnetoresistive effects) in the active layer, and sensitivity to magnetic fields can be improved. Further, waveform distortion in reproduction output of the head can be inhibited, satisfactory reproduction output can be obtained, and electromagnetic transducing efficiency and recording density can be improved.

FIG. 5A

**Description**

BACKGROUND OF THE INVENTION

1. Field of the Invention

The present invention relates to a magnetoresistive device, and more particularly, relates to a magnetoresistive device of a spin-valve type which exhibits giant magnetoresistive effect (GMR) and is suitable for a reproduction head or the like to be used for a magnetic recording apparatus such as a magnetic sensor or a magnetic disk unit.

2. Description of the Related Arts

Magnetoresistive films (MR films) are films composed of magnetic substances which exhibit magnetoresistive effect, and the films generally have a monolayer structure.

In contrast, GMR films have a multi-layer structure composed of a combination of a plurality of materials. There are some types of structures which produce a GMR effect. One of them is a spin-valve film which has a relatively simple structure and the resistance of which can be changed by a weak magnetic field.

Such a spin-valve film has a principal structure of a triple layer which is composed of a magnetic layer, a conducting non-magnetic layer and another magnetic layer, wherein these layers are stacked in the described order. And it is reported that such a spin-valve film exhibits a giant magnetoresistive (GMR) effect (Journal of Magnetism and Magnetic Materials, 93, p. 101-, 1991).

For example, in a magnetoresistive film having a spin-valve structure in which the magnetic layers are Co layers and the conductive layer is a Cu layer, spin-dependent scattering occurs according to the generation of an anti-parallel state of spin under the influence of an external magnetic field. This is recognized as the reason why a large magnetoresistance effect can be obtained.

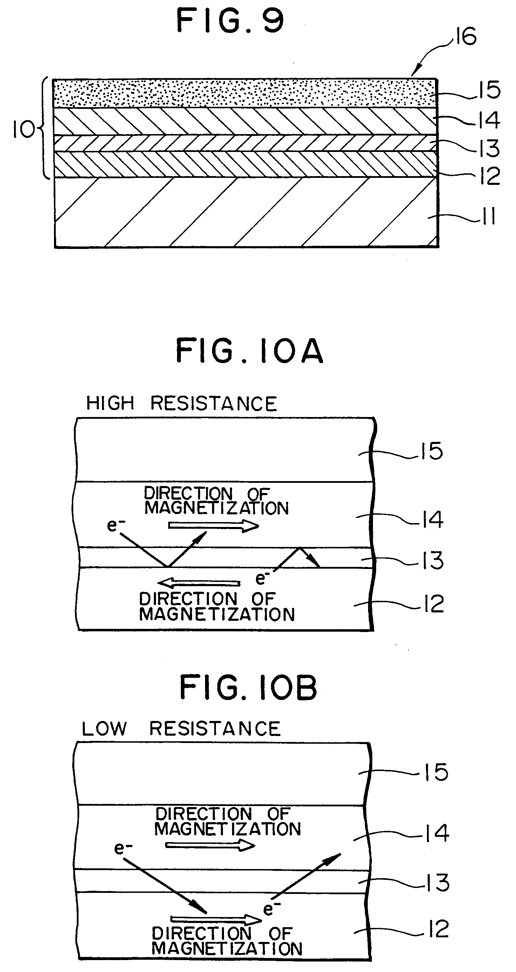

Fig. 9 shows an example of the magnetoresistive device 16 having said spin-valve structure. In this device, the following layers are stacked on a ferrite substrate 11 in the described order by a sputtering method to compose a magnetoresistive portion 10 which has a spin-valve structure: a magnetic layer 12 comprising permalloy (NiFe); a conducting non-magnetic layer 13 predominantly comprising Cu; another magnetic layer 14 comprising permalloy (NiFe) and/or Co; and an antiferromagnetic layer 15 comprising FeMn.

In a magnetoresistive device 16 having a spin-valve structure, two magnetic layers 12 and 14 are separated by a non-magnetic layer 13 and an antiferromagnetic layer 15 is provided on the latter magnetic layer 14. As a result, the magnetic layer 14 in contact with the antiferromagnetic layer 15 is in a state of being magnetized in a fixed direction (such a magnetic layer is named "magnetization fixation layer" or "pinning layer", and is referred to by such terms hereinafter). Meanwhile, the other magnetic layer 12 separated by the non-magnetic layer 13 is not magnetized in a fixed direction (such a magnetic layer is named "active layer" or "free layer", and is referred to by such terms hereinafter). In other words, the tendency to maintain the magnetization direction once fixed, namely, the coercive force, becomes strong in the pinning layer 14 while it becomes weak in the free layer 12.

A magnetic field applied to the above condition magnetizes the free layer 12 to fix the magnetization direction. When the magnetization direction of the free layer 12 is at an angle of 180° opposite to that of the pinning layer 14, as shown in Fig. 10 (A), the resistance of the film becomes maximum. This is because electrons moving from one of either the free layer 12 or the pinning layer 14 to the other scatter at the interface between the non-magnetic layer 13 and the magnetic layer 14.

In contrast, by equalizing the magnetization direction of the free layer 12 with that of the pinning layer 14, as shown in Fig. 10 (B), the resistance becomes minimum because the scattering hardly occurs at the interface between the non-magnetic layer 13 and the magnetic layer 14.

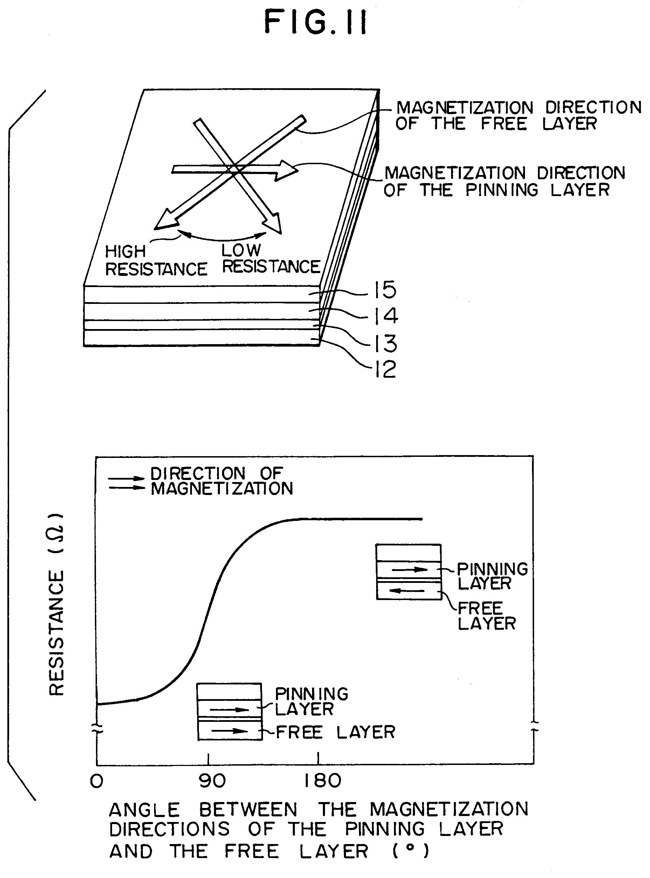

Fig. 11 shows such a resistance change by an external magnetic field. The ratio of resistance change, namely, [(Maximum resistance) - (Minimum resistance)]/(Minimum resistance), is about 4 - 10%, though it varies according to the material used, the thickness of the layers, and/or the like.

The operating principle of the above-described spin-valve structure is further explained below in detail.

The function of each layer which constitutes the spin-valve structure is summarized as follows.

Active layer (Free layer) 12:

In this layer, the direction of spin (i.e. magnetic moment) rotates in response to a signal magnetic field (i.e. external magnetic field, Hext).

Magnetization fixation layer (Pinning layer) 14:

The spin direction of the magnetic element is fixed by an exchange coupling with the antiferromagnetic layer 15 to be parallel with the direction of the signal magnetic field.

Non-magnetic layer 13:

This layer functions as a spacer for exhibition of the GMR effect. The resistance changes in accordance with the relative angle between spin directions of the active layer 12 and the pinning layer 14.

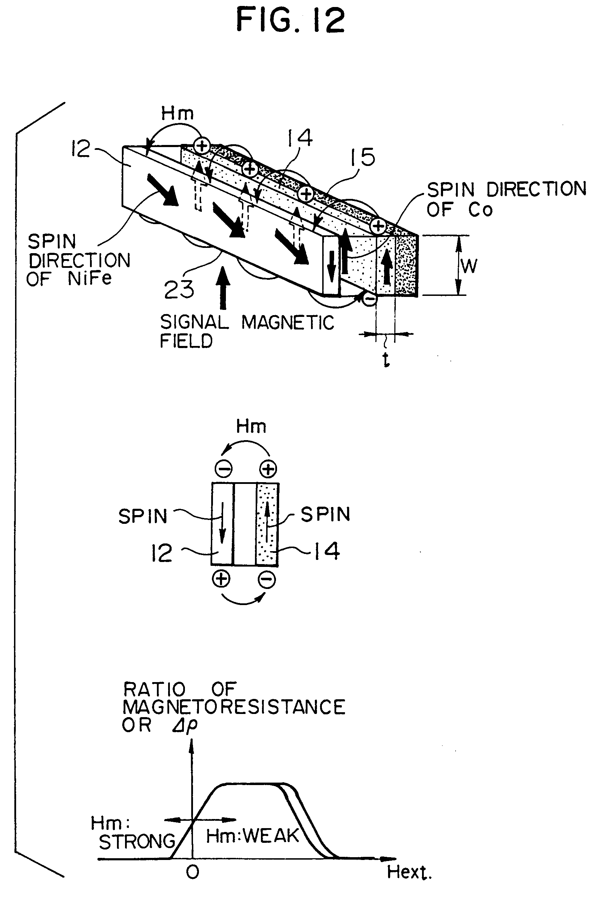

Fig. 12 shows a magnetic field Hm which is generated when the spin-valve film is finely processed into the form of a device. The magnetic poles (+) and (-) which are generated on the magnetization fixation layer 14 at the ends of the device generate the magnetic field Hm on the free layer 12. This basically corresponds to so called "SAL bias", namely, the pinning layer 14 corresponds to the SAL film and the free layer 12 corresponds to the MR (or GMR) film. Hm is adjusted by adjusting the saturation magnetization, Ms of the pinning layer 14, the thickness of the film, and the width of the device, W. In Fig. 12, Hm acts to make the spin of the free layer 12 to be directed downward. Additionally, ABS 23 is the sliding surface on which a magnetic recording medium slides. Here, "ABS" is the abbreviation of "Air Bearing Surface", and the same abbreviation is used below.

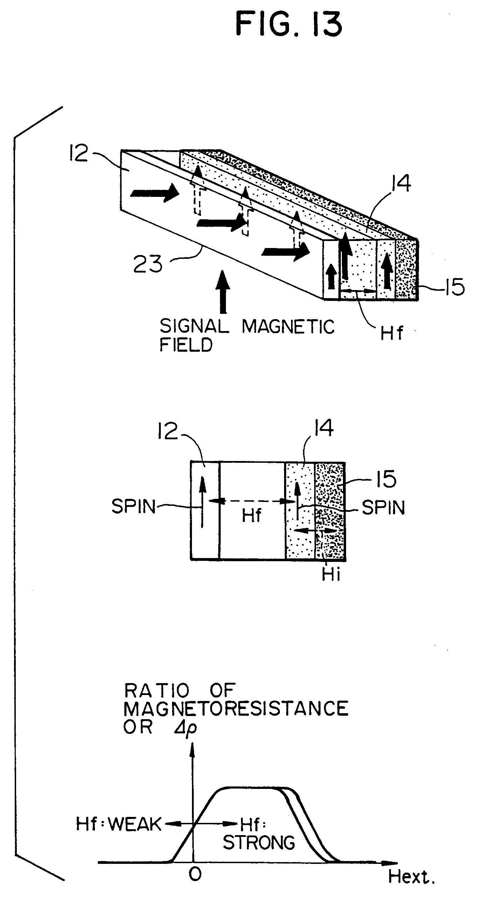

Fig. 13 shows a state where a magnetic field Hf is generated by interaction of two magnetic layers 12 and 14 through the thin spacer 13. With the thickness of the spacer 13 of 1.5 - 5.0 nm, the state is stable when the spins have the parallel and the same direction, and Hf increases as the thickness of the spacer 13 decreases (i.e., as the gap between two of the magnetic layers becomes narrower). The operating direction of Hf is always opposite to the direction of Hm illustrated in Fig. 12. In Fig. 13, therefore, Hf functions to make the spin of the free layer 12 to be directed upward.

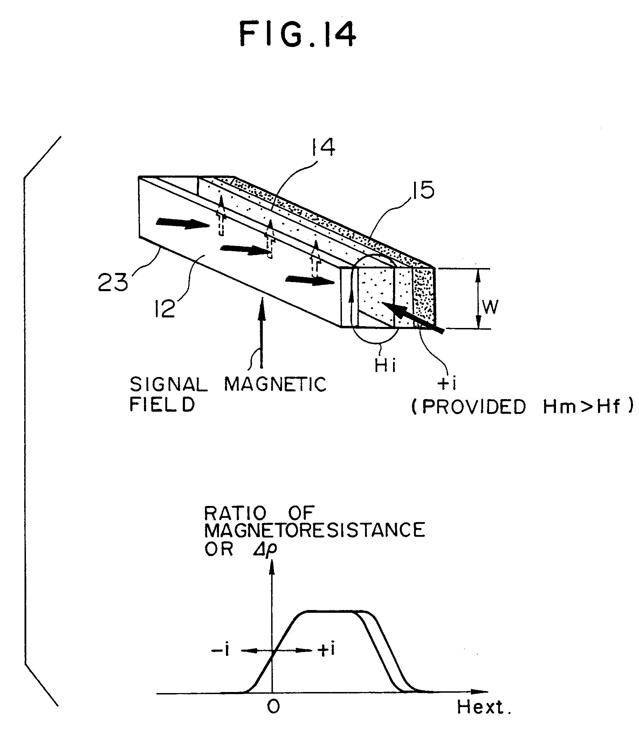

Fig. 14 shows a magnetic field, Hi generated by electric current. This follows the law of electromagnetic induction (the corkscrew rule). The electric current used herein is a sense electric current which is used for operation of devices. Since the direction of the sense electric current can optionally be selected, the Hi direction can also be selected. For example, Hi will be directed to +i when Hm > Hf (the thickness of free layer is 10 nm), and directed to -i when Hm < Hf (the thickness of free layer is 10 nm or less).

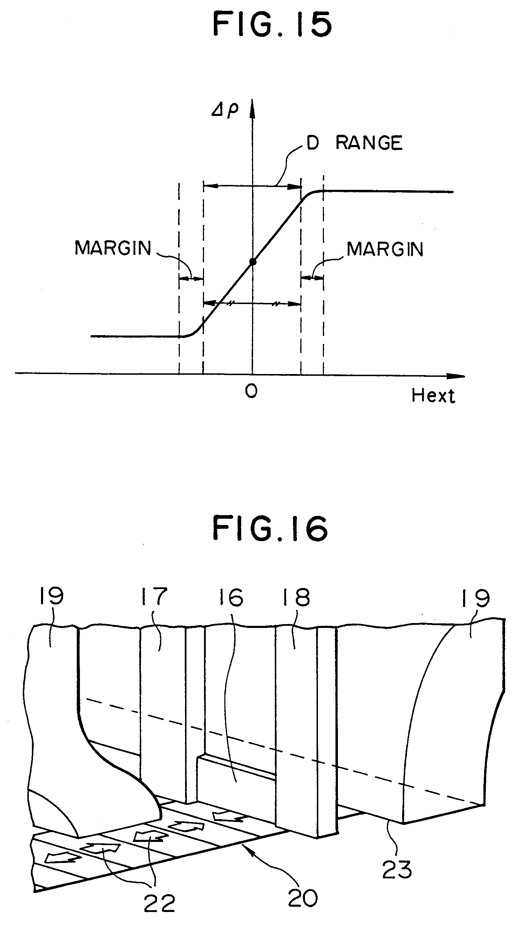

The device is then put into operation by balancing the above three magnetic fields, Hm, Hf and Hi. In other words, for operating the device, a dynamic range (D range) should be determined, wherein the D range is a range of magnetic field strength where the resistance of the device linearly varies. More specifically, the D range is determined by excluding some margins from a range of the magnetic field strength where the resistance of the device varies, as shown in Fig. 15. Hm, Hf and Hi are then balanced so that the middle of the D range should be the point where the external magnetic field affecting the device is zero, i.e., Hext = 0.

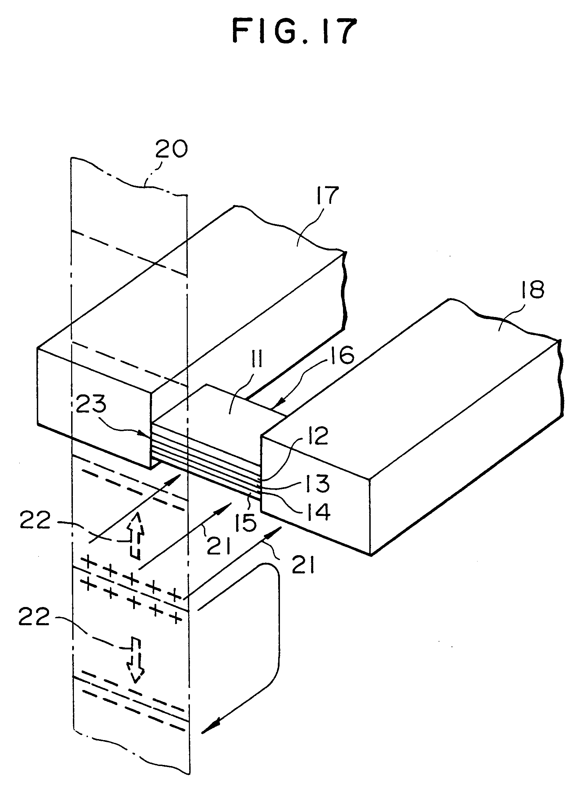

Figs. 16 and 17 show an example in which the above magnetoresistive device 16 having the spin-valve structure (SV device) is used for a reproducing head in an integrated recording/reproducing thin-film head of a hard disk drive. This reproducing head has a structure in which electrodes 17 and 18 are connected to the device 16, both upper and lower ends of which are sandwiched by magnetic shields 19. The head functions to reproduce signal magnetic fields 21 derived from a magnetic recording medium 20. In the figures, the symbols "+" and "-" indicate the magnetic poles of each magnetized region and arrows 22 indicate the directions of the magnetization spins.

The Inventor examined the above-described magnetoresistive device having the spin-valve structure (SV device) and found some problems as described below.

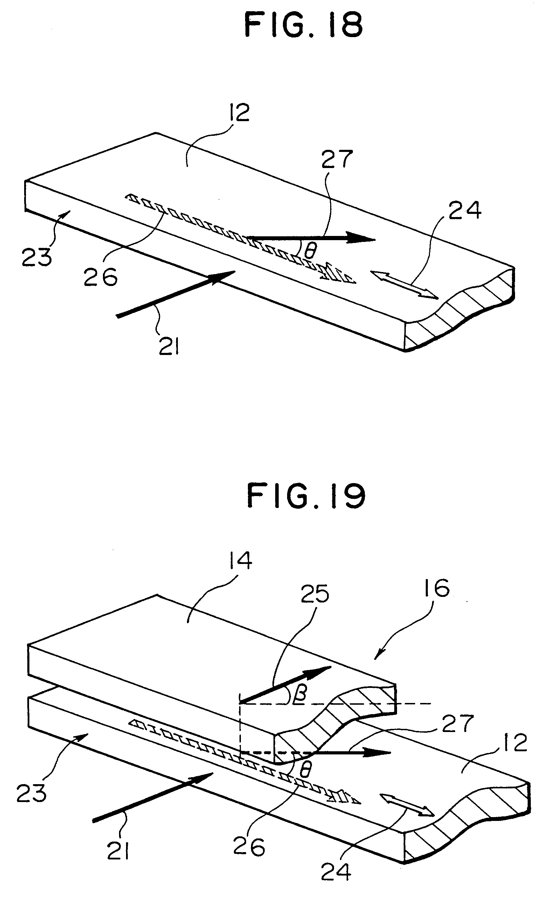

At first, matters relating to resistance change in a conventional SV device 16 will be illustrated by referring to Figs. 18 and 19. As to the magnetic anisotropy of the active layer 12, the easy magnetization axis is assumed to be parallel with the longitudinal direction of the ABS 23 of the head, and the direction 25 of exchange coupling between the magnetic layer 14 and the antiferromagnetic layer thereabove (not shown in the figures), namely, the magnetization direction 25 of the hard magnetic film is assumed to be perpendicular to the longitudinal direction of the ABS 23 of the head. In the conventional SV device 16, the thickness of the NiFe layer in the active layer 12 is about 10.0 nm, and there exist a transversal and a longitudinal anisotropic magnetoresistive effects (AMR) inherent in the NiFe layer itself.

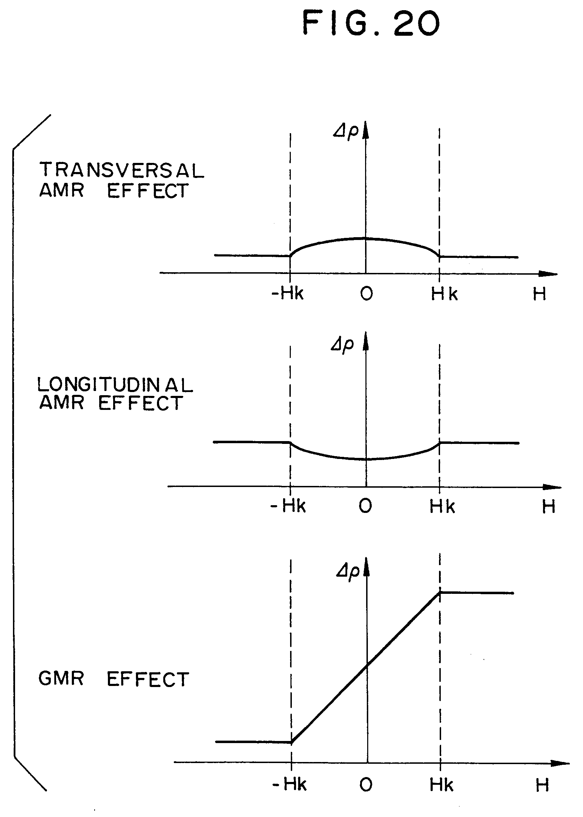

More specifically, these are resistance changes, or resistivity changes, $\Delta\rho$, which are generated according to rotation magnetization of the NiFe and are dependent on the angle $\theta$ between electric current 26 (sense current) and spin 27 as shown in Fig. 18. Fig. 20 shows the transversal AMR effect and the longitudinal AMR effect. The transversal AMR effect is expressed by a resistivity change curve having a upward-convex shape which has the maximum value at the point of $\theta = 0$. The longitudinal AMR effect, in turn, is expressed by a resistivity change curve which has a downward-convex shape.

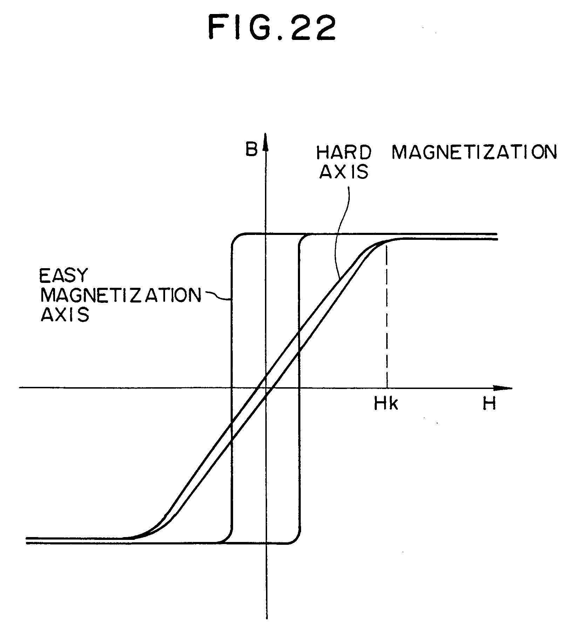

Incidentally, in soft magnetic films such as an NiFe film, the magnetic field strength for saturation of the rotation magnetization toward the hard magnetization axis (c.f. the B-H curve of Fig. 22) is named as "anisotropic magnetic field", Hk.

Meanwhile, the GMR effect inherent in the SV device which has a spin-valve structure corresponds the resistivity change which varies depending on the relative angle $\beta$ between the direction of spin 27 of the active layer (NiFe) 12 and the direction of spin 25 of the magnetic layer (or the hard magnetic layer) 14, as shown in Fig. 19. Here, the spin 25 of the magnetic layer (or hard magnetic layer) 14 is fixed or magnetically polarized perpendicularly to the electric current 26. When the dependence of the GMR effect of the SV device on the relative angle $\beta$ is understood as the dependence of the GMR effect on the magnetic field H, the resistivity change can be graphed as Fig. 20, the bottom diagram. The GMR effect inherent in the device is expressed as a point-symmetric linear resistance change with its center being the point of H = 0 (i.e., $\beta = 90°$, $\theta = 0°$).

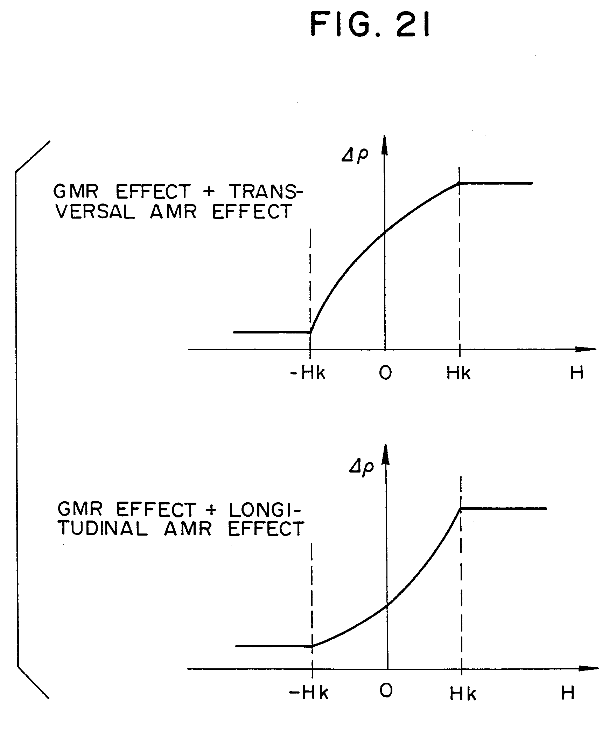

Then, the resistance changes when the above AMR effects are individually superimposed on the GMR effect are shown in Fig. 21. In the superimposition of the AMR effects on the GMR effect, each of the AMR effects is simply added to the GMR effect. Therefore, the resistivity change curve of the SV device will have an upward-convex shape when the transversal AMR effect is superimposed, while the curve will have a downward-convex shape when the longitudinal AMR effect is superimposed. Consequently, the favorable linearity of the resistivity change curve observed in the GMR effect inherent in the SV device will deteriorate according to the degree of superimposition of the AMR effects.

Actual AMR effects were then observed on a plain film (i.e., a film before being processed into a head or the like) which has the structure of Fig. 9. The transversal AMR effect is measured as a resistance change of the film which depends on the the strength of a magnetic field, when an external magnetic field is impressed in the same direction as that of the hard magnetization axis of the AMR film (active layer) 12 while the electric current is applied parallel with the direction of the easy magnetization axis 24. Meanwhile, the longitudinal AMR effect can be measured when the application direction of electric current is arranged to be the same as that of the hard magnetization axis.

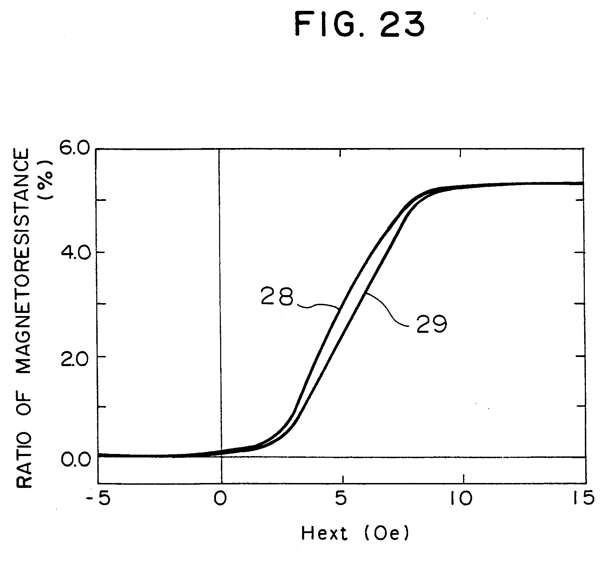

Fig. 23 is a diagram showing the dependence of the resistance change on the direction of an applied electric current in a conventional plain film. The sample used herein was an SV film which had the following structure: base layer/active layer 12/non-magnetic layer 13/pinning layer 14/ antiferromagnetic layer 15/protective layer = Ta 6.7 nm/NiFe 10.0 nm/Cu 2.4 nm/Co 2.2 nm/FeMn 10.0 nm/Ta 8.0 nm. Resistance change curves obtained in the measurements of the transversal and longitudinal effects have upward-convex shape (curve 28) and downward-convex shape (curve 29), respectively. It is, therefore, obvious that the AMR effects were superimposed.

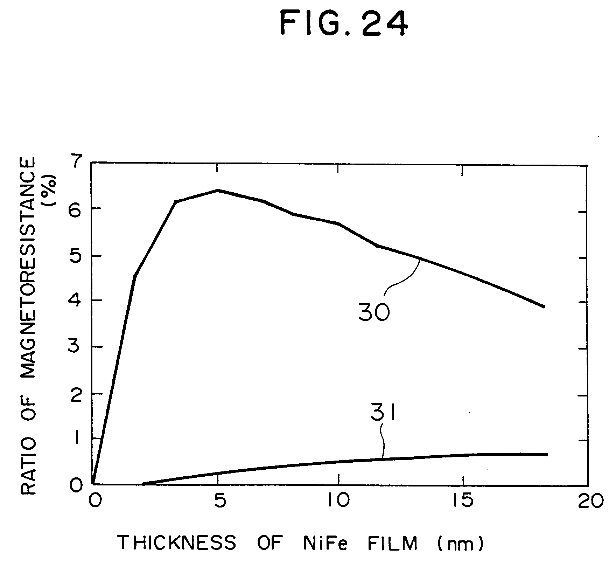

Next, Fig. 24 is a diagram showing the dependence of the GMR effect and that of the transversal AMR effect on the thickness of the active layer. The samples used herein were an SV film 30 having the following structure: Ta 6.7 nm/NiFe 18.3 nm or less/Cu 2.4 nm/Co 2.2 nm/FeMn 10.0 nm/Ta 8.0 nm; and an AMR film 31 having the following structure: Ta 6.7 nm/NiFe 18.3 nm or less/Cu 2.4 nm/Ta 8.0 nm. Both of the sample films were produced using a dc magnetoron sputtering system. As to the transversal AMR effect, measurement of the resistance was performed employing 4-point probe method and each $\Delta\rho/\rho$ was measured. It is known that transversal AMR effect abruptly decreases when the thickness of a film becomes extremely thin. The result shown in Fig. 24, however, exhibits that the $\Delta\rho/\rho$ according to the AMR effect still remains in the proportion of 10% to the $\Delta\rho/\rho$ according the GMR effect even when the thickness is about 10 nm. The AMR effect, therefore, can not be ignored in comparison with the GMR effect.

## SUMMARY OF THE INVENTION

Objects of the present invention are, with respect to a magnetoresistive device having a multi-layer structure which is composed of an active layer, a non-magnetic layer and a magnetization fixation layer, to improve linearity of operating characteristics of the device by inhibition of AMR effects (anisotropic magnetoresistive effects) in the active layer, and to improve sensitivity to magnetic fields. Further, other objects of the present invention are to reduce waveform distortion in reproduction output of the head, to obtain satisfactory reproduction output, and to improve electromagnetic transducing efficiency and recording density when the device is used for a thin-film magnetic head of a magnetoresistive type.

The inventor has earnestly investigated into the above-described problems of the prior art, and has unexpectedly found that the AMR effect can be sufficiently reduced to a negligible degree in comparison with the GMR effect if the thickness of the above-mentioned active layer (free layer) is restricted within a specific range of thickness, and finally, achieved the present invention.

Accordingly, the present invention relates to a magnetoresistive device, particularly a spin-valve type giant-magnetoresistive device, SV device, having a multi-layer structure comprising the following layers: an active layer (free layer) in which the direction of the magnetization spin (i.e. magnetic moment) rotates in response to an external magnetic field; a non-magnetic layer (spacer); and a magnetic layer for magnetic fixation (pinning layer or hard magnetic layer), wherein these layers are stacked in the described order or the reverse of said order, and wherein the thickness of the said active layer is 5.0 mm or less.

According to the magnetoresistive device of the present invention, since the thickness of the active layer is extremely thinner than those of conventional devices (about 10 nm), the above-described transversal and longitudinal AMR effects can be canceled and the linearity of the magnetoresistive effect is not distorted even by superimposition of said AMR effects, and therefore, the linearity of the operating characteristics of the device is markedly improved. Further, since demagnetizing fields decrease when the active layer becomes extremely thin, the sensitivity of the device to magnetic fields is also improved. This may be explained by an inference that the magnetic flux passing through the active layer considerably decreases since the active layer is as extremely thin as 5 nm or less, and therefore, the device would exhibit magnetic properties similar to those which the plain film exhibits.

Accordingly, below-described advantages can be obtained.

(1) The linearity of the operating characteristics of the device is improved and waveform distortion in reproduction output of a head can be reduced, so that the electromagnetic transducing efficiency is improved and the recording density becomes high.
(2) Due to the improvement in the sensitivity of the device to magnetic fields, sufficient reproduction output can be obtained even with a narrowly gapped head. Recording density, therefore, becomes high.

In the magnetoresistive device of the present invention, the following can be used as the material of the above-described active layer: permalloys which are used for a conventional SAL material such as NiFe, NiFeCo and NiFeTa; NiFe-X (X = Ag, B, Bi, C, Cr, Hg, Ir, Li, Mo, Na, Nb, Pb, V, Pt, Zr, Hf, Pd, Ta, Rh, Al, Au, Si, Cu, Y or the like, or a plurality thereof); a material such as Co, CoFe, CoFeB, CoNi or the like; CoZr, CoZr-X, CoZrN-X amorphous (X may be the same as the above) or the like; and others. Cu or Cu alloys such as CuNi or CuAg can be used as the material of the above-described non-magnetic layer. Further, a combination of a magnetic sub-layer (pinning layer) comprising NiFe, NiFeCo, Co, CoFe, CoNi or the like and an antiferromagnetic sub-layer comprising FeMn, NiMn, NiO, NiCoO or the like is available for the above-described magnetic layer. A hard magnetic layer comprising CoPt, CoCrTa or the like may also be used as a substitute for the combination of the sub-layers.

In the magnetoresistive device, the above-described non-magnetic layer functions actually as a spacer the resistance of which is altered according to the relative angle between the directions of the magnetization spins of the active layer and the magnetic layer. Further, when the above-described magnetic layer for magnetization fixation comprises a magnetic sub-layer and an antiferromagnetic sub-layer, the spin direction of the magnetization in the magnetic sub-layer may be fixed to be parallel with that of an external magnetic field by an exchange coupling therebetween. Meanwhile, when the above-described magnetic layer for magnetization fixation is composed of a hard magnetic layer, the spin direction of magnetization in the hard magnetic layer may be fixed to be parallel with that of the external magnetic field.

To obtain similar advantages by canceling the AMR effects as described above, an element such as Ta which reduces the anisotropic magnetoresistance may be added, as described below, to the active layer which constitutes the multi-layer structure together with the non-magnetic layer and the magnetic layer for magnetization fixation, these layers being stacked in the described order or the reverse of said order in the same manner as the above description. Advantages similar to the above can be also obtained by forming the active layer with a soft magnetic material such as NiFeTa which originally has very small AMR effects. Particularly, use of a material having good soft magnetic properties improves the sensitivity of the active layer to a magnetic field.

Further, in the magnetoresistive device of the present invention, the AMR effects may be canceled also by a combination of at least two means selected from the three, namely, by restricting the thickness of the active layer within 5.0 nm, adding some elements which reduce AMR effects to the active layer, and forming the active layer with a soft magnetic material which has very small AMR effects.

The use of an active layer in which AMR effects are canceled is a feature of the magnetoresistance-effective device of the present invention. However, when the GMR effect appears to be reduced due to the use of such an active layer, it is preferable to provide between the active layer and the non-magnetic layer a thin magnetic layer composed of NiFe, NiFeCo, Co, CoFe, CoNi or the like to compensate for the reduction.

Practically, in the magnetoresistive device of the present invention, a base layer composed of Ta or the like which aligns crystal orientation of the above-described antiferromagnetic layer to bring out antiferromagnetism may be provided under the multi-layer structure.

Further, a protective layer composed of Ta or the like may be preferably provided on the multi-layer structure. A head to be produced may have an upper magnetic pole composed of a soft magnetic material and a lower magnetic pole composed of a soft magnetic material, which are provided respectively on and under the multi-layer structure.

Needless to say, finished products like thin-film magnetic heads as well as the devices themselves such as SV devices fall under the concept relating to the magnetoresistive device of the present invention.

BRIEF DESCRIPTION OF THE DRAWINGS

Fig. 1 is a comparative diagram exhibiting the dependence of the characteristic of an SV device on the thickness of the NiFe layer (active layer).

Fig. 2 is a diagram showing the characteristic of an SV device with an NiFe layer (active layer) of 4.0 nm in thickness.

Fig. 3 is a comparative diagram showing the characteristics of a conventional SV device and a SV device of the present invention.

Fig. 4 is also a comparative diagram showing the characteristics of a conventional SV device and a SV device of the present invention.

Figs. 5A and 5B are schematic perspective views of two examples of a Type 1 SV device according to the present invention.

Figs. 6A and 6B are schematic perspective views of two examples of a Type 2 SV device according to the present invention.

Fig. 7 is a schematic perspective view, partially broken away, of an example of a Type 1 SV device according to the present invention.

Fig. 8 is a schematic perspective view of a sputtering system for producing a SV device according to the present invention.

Fig. 9 is a schematic sectional view of a conventional SV device.

Figs. 10A and 10B are schematic illustrations for explaining the operating principle of a conventional SV device.

Fig. 11 is a diagram showing a resistance change in a conventional SV device.

Fig. 12 depicts the operating principle of a conventional SV device, indicating the magnetostatic coupling magnetic field Hm.

Fig. 13 depicts the operating principle of a conventional SV device, indicating the ferromagnetic exchange interaction, Hf.

Fig. 14 depicts the operating principle of a conventional SV device, indicating the electric current inducing magnetic field, Hi.

Fig. 15 is a diagram indicating a dynamic range for the linear operation of a conventional SV device.

Fig. 16 is a perspective view of a principal part of a thin-film MR reproducing head comprising a conventional SV device.

Fig. 17 is a schematic perspective view indicating the action of a signal magnetic field derived from a magnetic recording medium.

Fig. 18 depicts the operating principle of an AMR device.

Fig. 19 depicts the operating principle of a SV device.

Fig. 20 shows resistivity change curves corresponding to the transversal AMR effect, the longitudinal AMR effect, and the GMR effect.

Fig. 21 shows resistivity change curves corresponding to the transversal AMR effect + the GMR effect, and the longitudinal AMR effect + the GMR effect.

Fig. 22 shows the B-H hysteresis loops of a soft magnetic film.

Fig. 23 is a diagram exhibiting dependence of the resistance change curve of a conventional device on the direction of the electric current.

Fig. 24 is a diagram exhibiting dependence of the GMR effect and the AMR effect on the thickness of the active layer.

DESCRIPTION OF THE PREFERRED EMBODIMENTS

The present invention will further be explained in detail referring to the following embodiments.

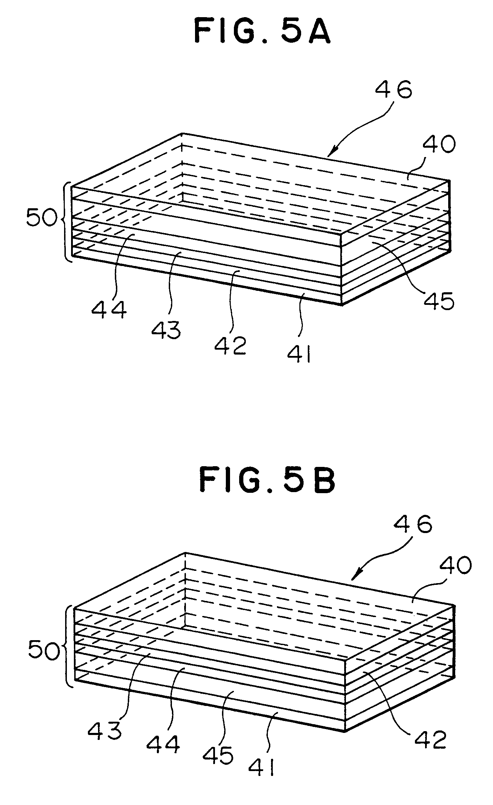

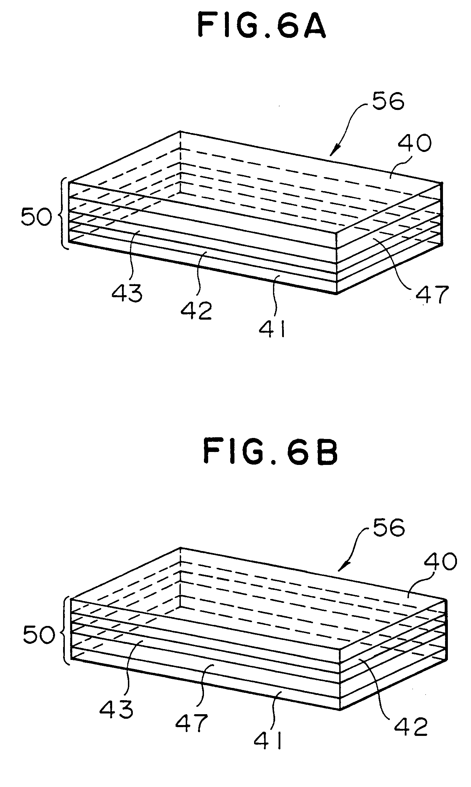

First of all, the composition of magnetoresistance-effective devices as embodiments of the present invention that have the spin-valve structure (SV devices) is illustrated referring to Figs. 5 and 6. The SV devices are classified broadly into 2 types. For the sake of convenience, one of them is named as "Type 1" (illustrated by Fig. 5), and the other is named as "Type 2" (illustrated by Fig. 6).

In a SV device 46 of Type 1, as shown in Fig. 5 (A), the magnetoresistive portion 50 is composed of a base layer 41, an active layer (free layer) 42, a non-magnetic layer (spacer) 43, a magnetic layer (pinning layer) 44, an antiferromagnetic layer 45 and a protective layer 40 that are stacked in the described order. As shown in Fig. 5 (B), stacking may be done in the order of the base layer 41, the antiferromagnetic layer 45, the magnetic layer (pinning layer) 44, the non-magnetic layer (spacer) 43, the active layer (free layer) 42 and the protective layer 40, namely, reversing the above-described order except for the base layer 41 and the protective layer 40.

In a SV device 56 of Type 2, as shown in Fig. 6 (A), the magnetoresistive portion 50 is composed of a base layer 41, an active layer (free layer) 42, a non-magnetic layer (spacer) 43, a hard magnetic layer 47, and a protective layer 40 which are stacked in the described order. As shown in Fig. 6 (B), stacking may be done in the order of the base layer 41, the hard magnetic layer 47, the non-magnetic layer (spacer) 43, the active layer (free layer) 42 and the protective layer 40, namely, reversing the above-described order except for the base layer 41 and the protective layer 40.

In each Type 1 or 2, an upper magnetic pole and a lower magnetic pole are provided respectively on and under the lamination and a pair of leader electrodes (c.f. Fig. 16) is provided at both sides of the lamination, though these are not illustrated in Figs. 5 and 6.

Practical composition of the lamination for Type 1 is as follows:

as the base layer 41: Ta, Ti, Hf or the like is deposited to a thickness of, for example, about 5.0 nm;
as the active layer 42: NiFe, NiFeCo, CoFe, CoFeB, CoNi, NiFe-X (wherein X is a substance containing Ta, Cr, Nb, Rh, Zr, Mo, Al, Au, Pd, Pt, Si or the like in a content of 30 atomic% or less), CoZr amorphous or the like is deposited to a thickness of, for example, about 15.0 nm or less (particularly, 5.0 nm or less);
as the non-magnetic layer 43: pure Cu, CuNi, CuAg or the like is deposited to a thickness of, for example, 1.5 - 5.0 nm (preferably, 2.0 - 3.0 nm);
as the magnetic layer 44: NiFe, NiFeCo, pure Co, CoFe, CoNi or the like is deposited to a thickness of, for example, 1.0 - 5.0 nm; and
as the antiferromagnetic layer 45: FeMn, NiMn, NiO, NiCoO or the like is deposited to a thickness of, for example, 5.0 - 100.0 nm (preferably, 5 - 15 nm in FeMn or NiMn, 30 - 60 nm in NiO or NiCoO).

The protective layer 40 may be a non-magnetic layer similar to the base layer 41.

As described above, the multi-layer structure may be inverted bottom-to-top. However, when FeMn or the like is used for the antiferromagnetic layer 45, a base layer which brings out the antiferromagnetic property of the antiferromagnetic layer 45 is required. In such a case, the base layer should preferably be a lamination composed of, for example, the above-described base layer 41 and an NiFe layer, or the above-described base layer 41 and a Cu layer.

Type 2 has a composition in which the hard magnetic layer 47 is substituted for a structural part of Type 1, namely, the part of magnetic layer 44/antiferromagnetic layer 45. The material of the hard magnetic layer 47 is not limited as long as it is a hard magnetic material such as CoPt, CoPtCr or CoCrTa conventionally used for a thin-film recording medium. Further, as described above, the multi-layer structure may be inverted bottom-to-top. Additionally, the base layer 41 and the protective layer 40 are unnecessary in some Type 2 devices.

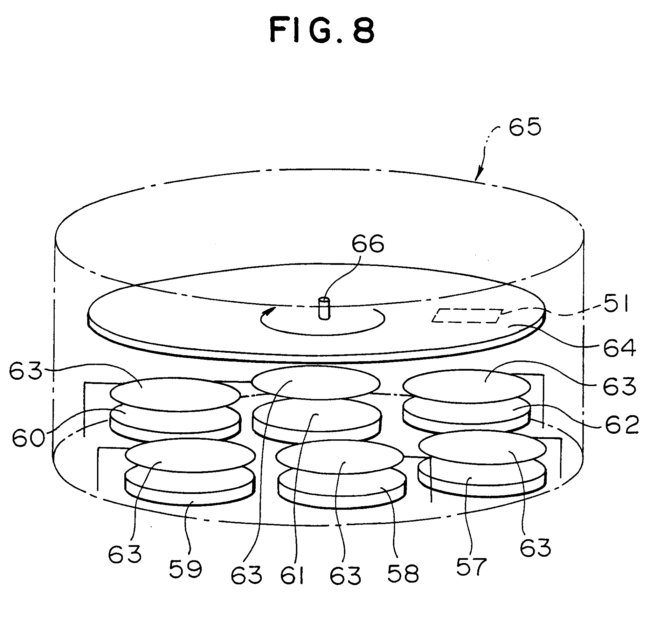

A dc magnetron sputtering system as shown in Fig. 8 can be used for producing the SV device of, for example, Type 1. In Fig. 8, 57 indicates a target for the base layer or the protective layer, 58 indicates a target for the active layer, 59 indicates a target for the magnetic layer, 60 indicates a target for the non-magnetic layer, 61 indicates a target for the magnetic layer, 62 indicates a target for the antiferromagnetic layer, 63 indicates shutters, 64 indicates a rotary substrate-holder, and 65 indicates a vacuum housing.

Actually, the vacuum housing 65 is divided into, for example, individual chambers with shield plates (not shown in Fig. 8), and the substrate holder 64 rotates successively on the rotation axis 66 by a predetermined angle to span all of the chambers. In each of the chambers, the target would be sputtered when the shutter opens, and thereby each of the layers described above would be deposited on the substrate 51 through an opening provided in the shield.

The dc magnetron sputtering system is designed to improve the sputtering efficiency by means of magnets that are not shown in Fig. 8. The sputtering condition used was the following: the sputtering gas was Ar the pressure of which was 0.5 Pa; the rate of deposition was 0.1 - 0.5 nm/sec.

SV devices 46 and 56, embodiments according to the present invention, can be used as GMR devices for, for example, a recording/reproducing integrated thin-film head for a hard disk drive as described above by referring to Figs. 16 and 17.

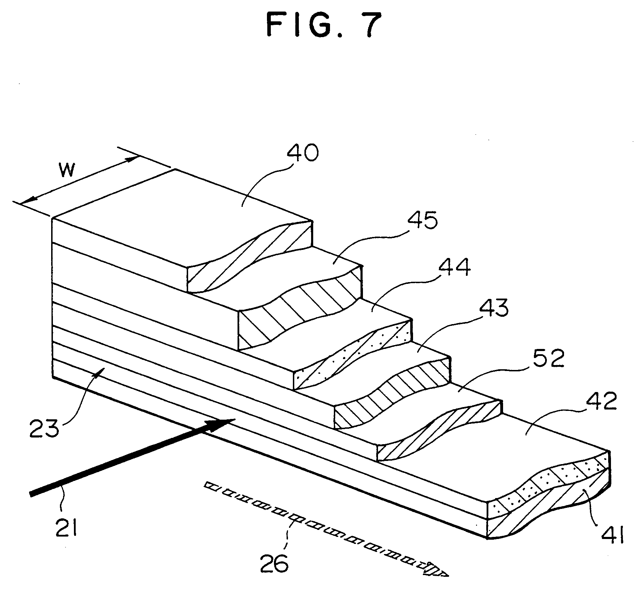

Fig. 7 shows an SV device as an example of Type 1. The operating principle is the same as that shown in Figs. 10 - 19. The function of each layer will be summarized below.

Base layer 41:

This layer is necessary to align crystal orientation of the antiferromagnetic layer 45 so as to bring out its antiferromagnetism.

Active layer (free layer) 42:

The spin direction of this layer rotates according to a signal magnetic field (external magnetic field: Hext).

Interfacial magnetic layer (free layer) 52:

This layer is the same as active layer 42 and may be provided to compensate the reduced GMR effect.

Magnetic layer (pinning layer) 44:

The spin directions of Co and others are fixed so as to be parallel with the direction of the signal magnetic field by exchange coupling with the antiferromagnetic layer 45.

Non-magnetic layer (spacer) 43:

A spacer film for exhibition of GMR effect. The resistance of this layer changes according to the relative angle between spin directions of the active layer 42 and the pinning layer 44.

Protective layer 40:

This layer prevents the spin-valve film from deterioration which may be caused during the process for producing the device.

In the SV devices according to the present invention, it should be noted that the AMR effects in the above-described active layer 42 (which is composed of, for example, NiFe) are canceled by making the thickness of the layer as extremely thin as 5.0 nm or less. This will be explained below in detail.

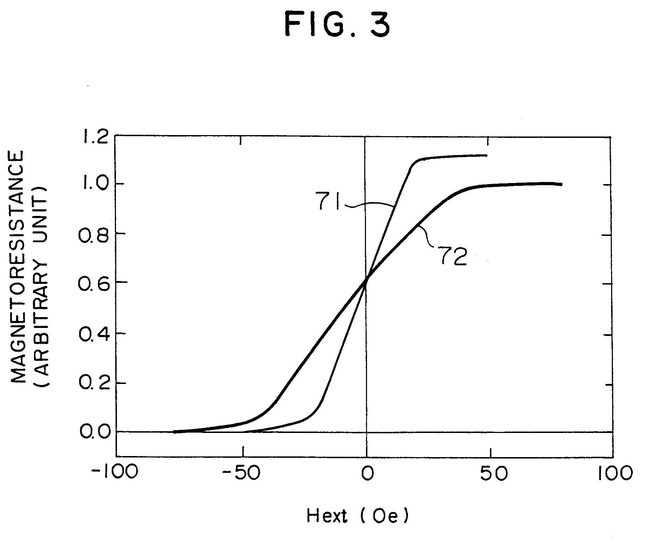

Fig. 3 shows properties of an SV device (curve 71) as an embodiment according to the present invention. The structure of the plain SV film used herein is Ta 6.7 nm/NiFe 5.0 nm/Cu 2.4 nm/Co 2.2 nm/FeMn 10.0 nm/Ta 8.0 nm. For comparison, the resistance change curve 72 of a conventional SV device is also shown in Fig. 3. Each device has the same shape of 100 $\mu$m in length, 2 $\mu$m in MR device height, W and 19 $\mu$m in distance between the electrodes. The sense electric current is 6 mA.

Obviously from the results shown in Fig. 3 in relation to the properties of the devices, the device according to the present invention, when compared with the conventional one, has much more excellent linearity in the operating characteristics. Further, in the device of the present invention, demagnetizing fields are reduced by making the active layer thinner, and therefore, sensitivity to magnetic fields is improved.

The ratio of magnetoresistance, $\Delta R/R$ was calculated according to the equation $(\Delta R/R) = (R-R_0)/R_0$, wherein R is the resistance in an external magnetic field H, and $R_0$ is the resistance in the external magnetic field of 1 KOe. Further, the sensitivity to magnetic fields was defined as the differential of the ratio of magnetoresistance by the external magnetic field, and was calculated according to the expression $d(\Delta R/R)/dH$. (The calculation in other devises was done in the same manner.)

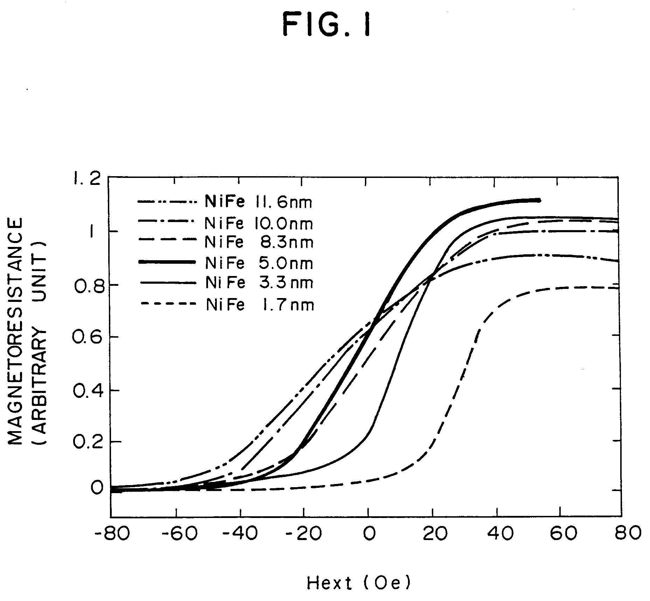

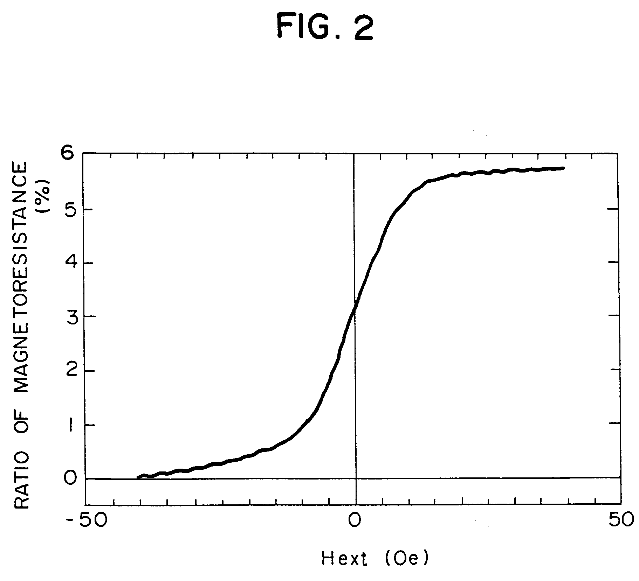

Figs. 1 and 2 show properties of a SV device observed when the thickness of the active layer is varied. The following would be understood from Figs. 1 and 2. When the thickness of the active layer ranges between 11.6 nm and 8.3 nm, the curve of magnetoresistance becomes roundish and an upper convex shape in the region where the magnetoresistance alters, and therefore, the linearity becomes poor. Meanwhile, when the thickness is 5.0 nm, the linearity becomes markedly excellent. Further, when the thickness is between 5.0 nm and 1.7 nm inclusive, the magnetoresistance alters relatively linearly. It is, therefore, obvious from the above that the present invention is advantageous.

Accordingly, the thickness of the active layer should be 5.0 nm or less. Particularly, when the thickness is 5.0 nm, the balance of the above-described Hm, Hf and Hi (shown in Figs. 12 - 15) is favorable and both of the linearity and sensitivity will be satisfactory. The balance tends to be unsatisfactory when the thickness is 1.7 nm or 3.3 nm. Incidentally, Fig. 2 is based on data obtained when the device has a structure of Ta 6.5 nm/NiFe 4.0 nm/Cu 2.4 nm/Co 2.9 nm/FeMn 10.0 nm/Ta 7.4 nm, and is 100 $\mu$m in length, 2 $\mu$m in height and 19 $\mu$m in distance between the electrodes, and when the sense electric current is 4 mA. As is obvious from Fig. 2, the above-described balance is favorable and the bias point is satisfactory in such a thickness.

From the above findings, the thickness of the active layer should be 5.0 nm or less when determined on the basis of the present invention. Further, it is predictable that 2.0 nm or more is preferable, 3.0 nm or more is more preferable, and 4.0 - 5.0 nm is even more preferable.

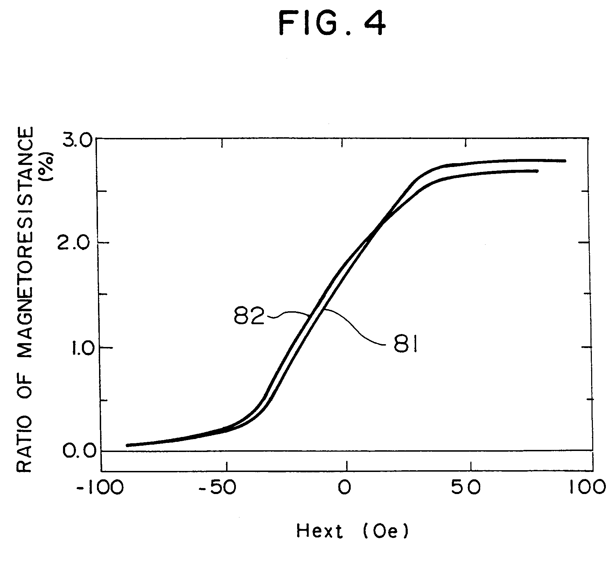

Additionally, Fig. 4 shows data obtained when the active layer is not composed of NiFe but is composed of a material such as NiFeTa which naturally has very small AMR effects and is more excellent in soft magnetic properties than NiFe. The multi-layer structure of the SV device 81 used herein is Ta 6.7 nm/NiFeTa 8.3 nm/NiFe 1.7 nm/Cu 2.4 nm/Co 2.2 nm/FeMn 10.0 nm/Ta 8.0 nm.

When a material other than NiFe, NiFeCo, CoFe and CoNi is used for the active layer, the GMR effect exhibited on the interface between the active layer and the Cu alloy layer decreases. In compensation for that, a thin layer composed of NiFe, NiFeCo, Co, CoFe, CoNi or the like (NiFe is used in this example) is placed between the active layer and the Cu alloy layer. For comparison, the properties of a conventional SV device 82 are also shown in Fig. 4. The shapes of the devices and the sense electric current are the same as described above. It is obvious from Fig. 4 that the device 81 based on the present invention has a satisfactory linearity without damage to the GMR effect.

Other than by use of NiFeTa as the principal material of the above-described active layer, a similar effect can be also obtained by use of substances as follows:

a so-called NiFe-X permalloy containing the element X which reduces the AMR effects, wherein X is a substance containing 30 atomic% or less of Ag, B, Bi, C, Cr, Hg, Ir, Li, Mo, Na, Nb, Pb, V, Pt, Zr, Hf, Pd, Ta, Rh, Al, Au, Si, Cu, Y or the like, or a plurality thereof;
a material such as Co, CoFe, CoFeB, CoNi or the like;

a material such as CoZr, CoZr-X or CoZrN-X amorphous or the like, wherein X may be the same as the above; and others.

Particularly preferable are NiFeTa, NiFeMo (super permalloy) and others that are excellent in soft magnetism.

Alternatively, the AMR effects can be reduced by adding a specific element to the active layer. Ag, B, Bi, C, Co, Cr, Fe, Hg, Ir, Li, Mo, Na, Nb, Pb, V, Pt and Zr may be included in such elements to be added. The amount of the element to be added to the active layer may suitably be 0.1 - 30 atomic%.

As described above, cancellation of the AMR effects in the active layer offers improved linearity of the operating characteristics of the SV device, to an extent greater than a conventional device. Further, an improvement in the soft magnetic properties of the active layer offers improvement in the sensitivity of the device to magnetic fields. By virtue of the above improvements, waveform distortion of reproduction output would be suppressed, a wide dynamic range can be obtained, and electromagnetic transducing efficiency would be improved. The reproducing properties of the head would, therefore, be improved. Additionally, the good sensitivity to magnetic fields will be maintained even when the signal magnetic field strength decreases, and the electromagnetic transducing efficiency does not deteriorate even when the device is used in a narrowly-gapped reproducing head. By virtue of these, much higher recording density can be achieved.

While some embodiments of the present invention were illustrated as described above, further modifications of the above embodiments may be carried out on the basis of the technical ideas of the present invention.

For example, in the above-described SV devices or heads, the number of layers in the multi-layer structure, the thickness of each layer, the materials, and others may be altered as required.

Further, the structure of the above-described heads may be modified so as to be applicable to various uses as heads for detecting magnetic fields.

Additionally, sputtering methods other than the dc magnetron sputtering which was employed in the above-described embodiments may be employed for deposition. Instead of the sputtering methods, vapor deposition and other method may also be employed for the deposition.

As described above, the present invention offers improved linearity of the operating characteristics of a device. According to the present invention, the device comprises an active layer (free layer) in which the direction of the magnetization spin (i.e. magnetic moment) rotates in response to an external magnetic field, a non-magnetic layer (spacer), and a magnetic layer for magnetization fixation (pinning layer or hard magnetic layer), said layers being stacked in the described order or the reverse of said order in the form of a multi-layer structure, and the thickness of said active layer being 5.0 nm or less. Making the thickness of the active layer 5.0 nm or less, which is much thinner than those in conventional devices, cancels the transversal and longitudinal AMR effects, prevents distortion of the linearity caused by superimposition of the AMR effects, and thus brings about the above improvement in linearity. Additionally, making the active layer extremely thin reduces demagnetizing fields, and thus offers improved sensitivity of the device to magnetic fields. This may be explained by the inference that the magnetic flux passing through the active layer fairly decreases and the magnetic properties equal to those of the plain film would be achieved since the active layer is as extremely thin as 5.0 nm or less.

## Claims

1. A magnetoresistive device, which has a multi-layer structure comprising an active layer in which the direction of the magnetization spin rotates, a non-magnetic layer, and a magnetic layer for magnetization fixation, wherein said layers are stacked in the described order or the reverse of said order, and wherein the thickness of said active layer is 5.0 mm or less.

2. The magnetoresistive device according to Claim 1, wherein the non-magnetic layer is a spacer the resistance of which alters in response to the relative angle between the direction of magnetization spin of the active layer and that of the magnetic layer.

3. The magnetoresistive device according to Claim 1, wherein the magnetic layer for magnetization fixation comprises a magnetic sub-layer and an antiferromagnetic sub-layer, and wherein an exchange coupling therebetween fixes the direction of magnetization spin of the magnetic sub-layer to be parallel with an external magnetic field.

4. The magnetoresistive device according to Claim 1, wherein the magnetic layer for magnetization fixation comprises a hard magnetic layer, and wherein the direction of magnetization spin of the hard magnetic layer is fixed to be parallel with an external magnetic field.

5. The magnetoresistive device according to Claim 1, wherein a base layer is provided under the multi-layer structure, said base layer aligning the crystal orientation of the antiferromagnetic layer to bring out its antiferromagnetism.

6. The magnetoresistive device according to Claim 1, wherein a protective layer is provided on the multi-layer structure.

7. The magnetoresistive device according to Claim 1, wherein an upper magnetic pole comprising a soft magnetic materials and a lower magnetic pole comprising a soft magnetic material are provided respectively on and under the multi-layer structure.

8. The magnetoresistive device according to Claim 1, wherein said device is a giant-magnetoresistive device of a spin-valve type.

9. A magnetoresistive device, which has a multi-layer structure comprising an active layer in which the direction of the magnetization spin rotates, a non-magnetic layer, and a magnetic layer for magnetization fixation, wherein said layers are stacked in the described order or the reverse of said order, and wherein said active layer contains an element capable of reducing anisotropic magnetic resistance.

10. The magnetoresistive device according to Claim 9, wherein a magnetic layer is further provided between the active layer and the non-magnetic layer.

11. The magnetoresistive device according to Claim 9, wherein the non-magnetic layer is a spacer the resistance of which alters in response to the relative angle between the direction of magnetization spin of the active layer and that of the magnetic layer.

12. The magnetoresistive device according to Claim 9, wherein the magnetic layer for magnetization fixation comprises a magnetic sub-layer and an antiferromagnetic sub-layer, and wherein an exchange coupling therebetween fixes the direction of magnetization spin of the magnetic sub-layer to be parallel with an external magnetic field.

13. The magnetoresistive device according to Claim 9, wherein the magnetic layer for magnetization fixation comprises a hard magnetic layer, and wherein the direction of magnetization spin of the hard magnetic layer is fixed to be parallel with an external magnetic field.

14. The magnetoresistive device according to Claim 9, wherein a base layer is provided under the multi-layer structure, said base layer aligning the crystal orientation of the antiferromagnetic layer to bring out its antiferromagnetism.

15. The magnetoresistive device according to Claim 9, wherein a protective layer is provided on the multi-layer structure.

16. The magnetoresistive device according to Claim 9, wherein an upper magnetic pole comprising a soft magnetic materials and a lower magnetic pole comprising a soft magnetic material are provided respectively on and under the multi-layer structure.

17. The magnetoresistive device according to Claim 9, wherein said device is a giant-magnetoresistive device of a spin-valve type.

18. A magnetoresistive device, which has a multi-layer structure comprising an active layer in which the direction of the magnetization spin rotates, a non-magnetic layer, and a magnetic layer for magnetization fixation, wherein said layers are stacked in the described order or the reverse of said order, and wherein said active layer comprises a soft magnetic material.

19. The magnetoresistive device according to Claim 18, wherein a magnetic layer is further provided between the active layer and the non-magnetic layer.

20. The magnetoresistive device according to Claim 18, wherein the non-magnetic layer is a spacer the resistance of which alters in response to the relative angle between the direction of magnetization spin of the active layer and that of the magnetic layer.

21. The magnetoresistive device according to Claim 18, wherein the magnetic layer for magnetization fixation comprises a magnetic sub-layer and an antiferromagnetic sub-layer, and wherein an exchange coupling therebetween fixes the direction of magnetization spin of the magnetic sub-layer to be parallel with an external magnetic field.

22. The magnetoresistive device according to Claim 18, wherein the magnetic layer for magnetization fixation comprises a hard magnetic layer, and wherein the direction of magnetization spin of the hard magnetic layer is fixed to be parallel with an external magnetic field.

23. The magnetoresistive device according to Claim 18, wherein a base layer is provided under the multi-layer structure, said base layer aligning the crystal orientation of the antiferromagnetic layer to bring out its antiferromagnetism.

24. The magnetoresistive device according to Claim 18, wherein a protective layer is provided on the multi-layer structure.

25. The magnetoresistive device according to Claim 18, wherein an upper magnetic pole comprising a soft magnetic materials and a lower magnetic pole comprising a soft magnetic material are provided respectively on and under the multi-layer structure.

26. The magnetoresistive device according to Claim 18, wherein said device is a giant-magnetoresistive device of a spin-valve type.

# FIG. 1

# FIG. 2

# FIG. 3

# FIG. 4

# FIG. 5A

# FIG. 5B

# FIG.6A

# FIG.6B

# FIG. 7

# FIG. 8

# FIG. 9

16

15

14

10 {

13

12

11

# FIG. 10A

HIGH RESISTANCE

15

DIRECTION OF
MAGNETIZATION

e⁻

14

13

e⁻

DIRECTION OF
MAGNETIZATION

12

# FIG. 10B

LOW RESISTANCE

15

DIRECTION OF
MAGNETIZATION

e⁻

14

13

e⁻

DIRECTION OF
MAGNETIZATION

12

# FIG. II

MAGNETIZATION DIRECTION OF THE FREE LAYER

MAGNETIZATION DIRECTION OF THE PINNING LAYER

HIGH RESISTANCE   LOW RESISTANCE

15
14
13
12

DIRECTION OF MAGNETIZATION

RESISTANCE (Ω)

PINNING LAYER
FREE LAYER

PINNING LAYER
FREE LAYER

0   90   180

ANGLE BETWEEN THE MAGNETIZATION DIRECTIONS OF THE PINNING LAYER AND THE FREE LAYER (°)

# FIG. 12

# FIG. 13

SIGNAL MAGNETIC FIELD

Hf

SPIN — Hf → SPIN

Hi

RATIO OF MAGNETORESISTANCE OR $\Delta\rho$

Hf:WEAK ← → Hf: STRONG

O          Hext.

# FIG.14

SIGNAL MAGNETIC FIELD

(PROVIDED Hm>Hf)

RATIO OF MAGNETORESISTANCE OR $\Delta\rho$

# FIG. 15

# FIG. 16

# FIG. 17

# FIG. 18

# FIG. 19

# FIG. 20

TRANSVERSAL
AMR EFFECT

LONGITUDINAL
AMR EFFECT

GMR EFFECT

# FIG. 2I

GMR EFFECT + TRANS-
VERSAL AMR EFFECT

GMR EFFECT + LONGI-
TUDINAL AMR EFFECT

# FIG.22

# FIG. 23

# FIG. 24